Europäisches Patentamt

European Patent Office

Office européen des brevets

(11) Publication number: **0 182 457 B1**

## EUROPEAN PATENT SPECIFICATION

(45) Date of publication of patent specification: **19.02.92**     (51) Int. Cl.⁵: **G11C 11/407**

(21) Application number: **85305818.8**

(22) Date of filing: **15.08.85**

(54) **A dynamic random access memory circuit and a method of stabilizing current surges in such a memory circuit.**

(30) Priority: **19.11.84 US 672907**

(43) Date of publication of application:
**28.05.86 Bulletin 86/22**

(45) Publication of the grant of the patent:
**19.02.92 Bulletin 92/08**

(84) Designated Contracting States:
**DE FR GB NL**

(56) References cited:
**EP-A- 0 143 591**
**US-A- 4 421 996**

**PATENT ABSTRACTS OF JAPAN, vol. 7, no.
212 (P-224)[1357], 20th September 1983, page
23 P 224; & JP-A-58 105 482 (FUJITSU K.K.)
23-06-1983**

**IDEM**

**IEEE JOURNAL OF SOLID-STATE CIRCUITS,
vol. SC-19, no. 5, October 1984, pages
591-596, IEEE, New York, US; K. MASHIKO et
al.: "A 70 ns 256K DRAM with bit-line shield"**

**PATENT ABSTRACTS OF JAPAN, vol. 4, no.**

**10 (E-167), 25th January 1980, page 59 E 167;
& JP-A-54 150 045 (TOKYO SHIBAURA DENKI
K.K.) 24-11-1979**

(73) Proprietor: **THORN EMI North America Inc.
P.O. Box 16000
Colorado Springs Colorado 80935(US)**

(72) Inventor: **Allan, James D.
1616 North Nevada Avenue
Colorado Springs Colorado 80907(US)**

(74) Representative: **Palmer, Roger et al
PAGE, WHITE & FARRER 54 Doughty Street
London WC1N 2LS(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

# Description

The present invention relates to a dynamic random access memory circuit and to a method of stabilizing current surges in such a memory circuit.

In the operation of a dynamic random access memory (DRAM), considerable power supply current surges may be generated. These typically result from the large capacitance associated with the bit lines, along which memory cells are located, which capacitance must be overcome during charging and discharging each cycle.

In DRAMs, the logical complement $\overline{RAS}$ of a row address strobe RAS is used to define a "cycle." Such a cycle may include nominally 100 to 120 nanoseconds, during which $\overline{RAS}$ will be high for 40 nanoseconds or so. The time between the high to low edge of $\overline{RAS}$ and the next low to high edge of $\overline{RAS}$ is called the "active period". When $\overline{RAS}$ is high in DRAMs of the prior art, precharging of the bit lines will occur. During the ensuing active period, the decoders are set up to access the intended memory cell. Afterwards, but still during the active period, the sensing and restore operations occur. These terminate when $\overline{RAS}$ goes high, signalling the end of the active period.

For example, in a fast 256K CMOS DRAM there are typically 1024 pairs of bit lines, each having a capacitance of typically 800 femtofarads (fF). When midpoint sensing is employed in such a DRAM, the DRAM must move a cumulative 800 pF. of capacitance from its precharged level of $V_{cc}/2$ to $V_{cc}$ during the time between the initiation of sensing and the termination of the active period (which ordinarily corresponds to the initiation of the precharge period).

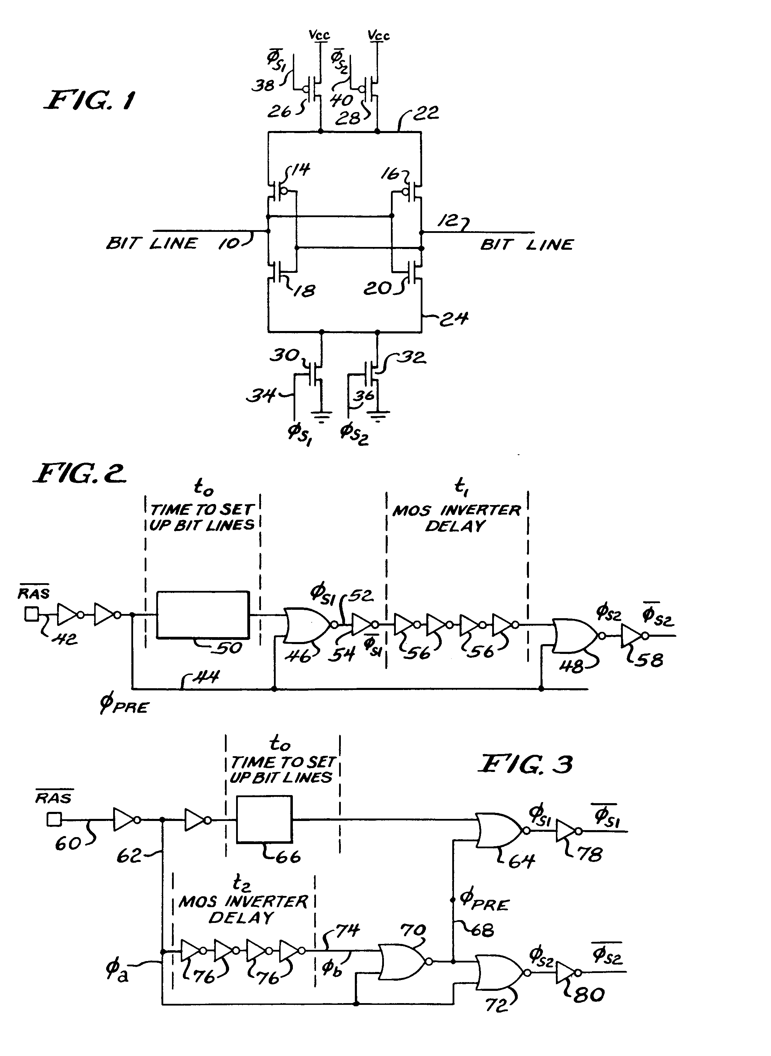

In a typical chip active period, sensing will generally be initiated approximately 30 nS. prior to termination of the active period. During this 30 nS. time frame, sense and restore signals must be supplied to a series of two or more pull-up transistors of a sense amplifier coupled to the bit lines, such as the DRAM sense amplifier represented in Figure 1. In a conventional DRAM design, a first sense and restore signal will turn on a relatively small pull-up transistor. Subsequent sense and restore signals will then each turn on a somewhat larger pull-up transistor or a pair of such transistors. In this fashion the amount of current drawn through the pull-up transistors into the DRAM circuits is controlled somewhat by the size of the transistor used. Also, the relative timing between the initiation of these signals will further help control the surge of current associated with turning on the transistors.

Figure 1 shows the circuit of a known dynamic RAM sense amplifier which comprises a flip-flop arrangement of paired P channel transistors 14 and 16, and paired N channel transistors 18, 20 arranged to amplify the differential developed between bit lines 10 and 12. The sense amplifier of Figure 1 is turned on by driving a line 22 towards $V_{cc}$ and driving a line 24 towards ground potential. The line 22 may be connected to $V_{cc}$ by turning on a set of P channel transistors represented by two P channel transistors 26 and 28. The line 24 may be driven towards ground potential by turning on a set of N channel transistors represented by two N channel transistors 30 and 32.

Traditionally, each of paired transistors 26 and 30 is a smaller device than each of paired transistors 28 and 32. These first transistors 26 and 30 will be turned on first, thereby limiting the maximum current which may surge through to the sense amplifier by the actual physical limitations on the size of transistors 26 and 30. Once these transistors have been turned on for a period of time, the larger transistors 28 and 32 will be turned on to deliver a larger current to complete the sense and restore operations.

In the circuit of Figure 1, the first N channel transistor 30 is turned on by receipt of a first sensing signal $\emptyset_{s1}$ on a line 34. Similarly, the second N channel transistor 32 is turned on by the receipt of a second sensing signal $\emptyset_{S2}$ on a line 36. Likewise, the first and second P channel transistors 26 and 28 are turned on by the receipt on lines 38 and 40 of the logical complements $\overline{\emptyset_{s1}}$, $\overline{\emptyset_{s2}}$ of the first and second sensing signals, respectively. The interval between the first and second sensing signals $\emptyset_{s1}$, $\emptyset_{s2}$ determines the amount of time for which the first smaller transistors 26 and 30 are on before the second, larger transistors 28 and 32 are also turned on. This time interval also determines the current which will be drawn through the second transistor 28 into the DRAM circuitry when it is first turned on by reducing the source to drain potential across the transistor 28 at that time.

This general method of turning on the transistors in a sense amplifier at differing times is used to overcome the capacitance of the bit lines 10 and 12. Consider that an amount of charge corresponding to the bit line capacitance must be supplied to the circuit. This may be done by supplying a large current for a short time or a small current for a longer time. In the method described with respect to Figure 1, the turning on of the smaller transistors such as transistors 26 and 30 first and leaving them on for a period of time causes a certain amount of charge to be transferred to bit lines 10 and 12 to overcome partially the parasitic capacitance and raise the potential at the bit lines before the larger transistors 28 and 32 are turned on. When they are turned on, the larger transistors allow a somewhat larger current to flow and deliver additional charge to the bit lines until they have been moved from a potential of $V_{cc}/2$ to $V_{cc}$. Thus, a sense amplifier as illustrated in Figure 1 may be turned on in stages by means of time-staggered sense and restore signals to turn on increasingly larger pull-up transistors illustrated by the two P/N channel transistor pairs 26/30 and 28/32. This provides a gradual increase in current instead of a relatively unmanagable current surge all at once which would result from turning on all transistor pairs together.

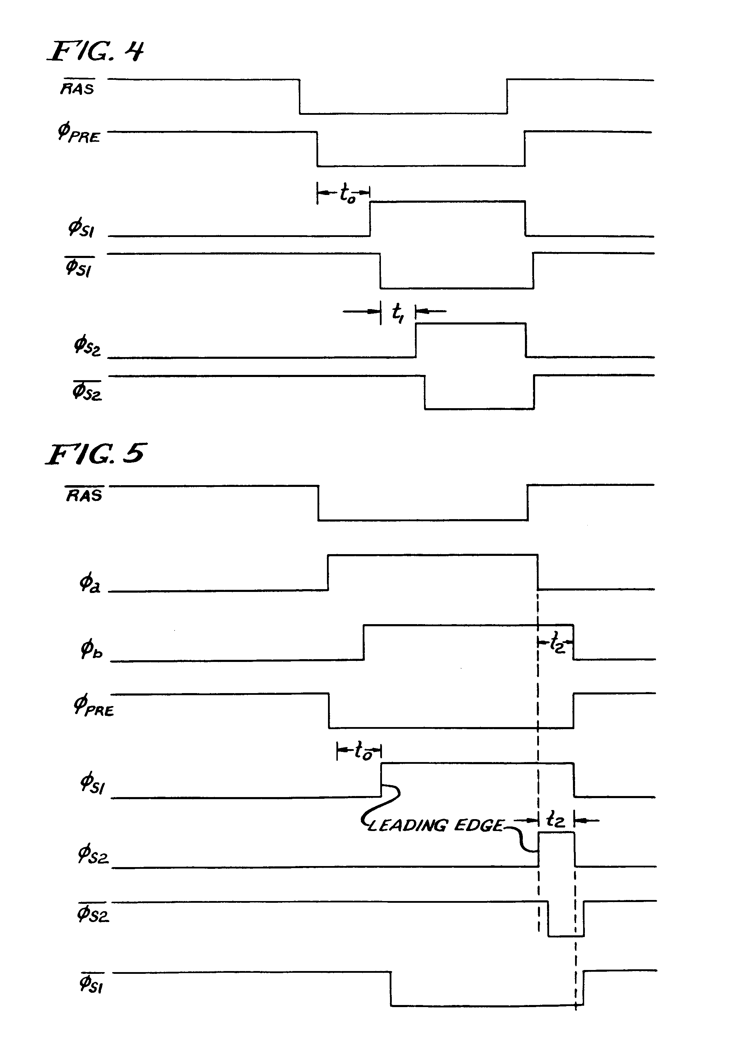

Conventional logic circuitry for providing such time-staggered sense and restore signals is illustrated in Figure 2. In this conventional circuit for attempting to control the current drawn through the sense amplifier, as the $\overline{RAS}$ signal goes low, a first sensing signal $\emptyset_{s1}$ will be initiated at a subsequent time $t_0$. The interval between $\overline{RAS}$ going low and $t_0$ is the time required to set up the bit lines for sensing. This time is dependent upon the conditions in which the DRAM is operating, for example, upon the temperature and upon the power supply voltage.

A second sensing signal $\emptyset_{s2}$ is generated after a delay time $t_1$ after initiation of the first sensing signal $\emptyset_{s1}$. Time $t_1$ may be controlled by a series of MOS inverters as shown in Figure 2 which interpose a delay determined by on-chip circuitry. For example, ten to twelve MOS inverters in series may be provided by the chip fabricator. When $\overline{RAS}$ goes high indicating the initiation of the precharge period, both sensing signals $\emptyset_{s1}$,$\emptyset s2$ are terminated by means of a $\emptyset_{pre}$ signal.

More particularly, in the illustrated logic circuitry of Figure 2, the row address strobe complement signal $\overline{RAS}$ is received on a line 42. It generates a first $\emptyset_{pre}$ signal on a line 44 to enable NOR gates 46 and 48 for later generation of the first and second sensing signals. The first sensing signal will be generated at a time $t_0$ following the initiation of the $\overline{RAS}$ signal as determined by the time required to set up the bit lines of the dynamic RAM, which time is represented by a delay block 50. The first sensing signal $\emptyset_{s1}$ is generated at a node 52 and is supplied to the sense amplifier via the line 34 (Figure 1). An inverter 54 generates the logical complement $\overline{\emptyset_{s1}}$ of the first sensing signal and supplies it to transistor 26 of the circuit of Figure 1 via the line 38.

The second sensing signal $\emptyset_{s2}$ will be generated at a time $t_1$ after the initiation of the first sensing signal $\emptyset s1$. The time $t_1$ is determined by a series of MOS inverters 56 arranged to create a predetermined delay between the first and second sensing signals. Thus, at a time $t_1$ after the initiation of the first sensing signal $\emptyset_{s1}$, the second sensing signal $\emptyset_{s2}$ will be generated at the output of the NOR gate 48 and fed via the line 36 (Figure 1) to the N channel transistor 32 of Figure 1. An inverter gate 58 is used to generate the logical complement $\overline{\emptyset_{s2}}$ of the second sensing signal which is arranged to turn on the larger transistor 28 of Figure 1 via the line 40. It is in this fashion that it has previously been attempted to control the current surge when bit line capacitance needs to be overcome.

However, this prior technique does have major disadvantages. A typical DRAM will be called upon to meet its specified access times over a large range of temperature, power supply and process parameters. Typically, in the worst case or slowest timing conditions a 30 nS. interval will be required between the first set of sense and restore signals $\emptyset_{s1}$ and $\overline{\emptyset_{s1}}$ and the second set of sense and restore signals $\emptyset_{s2}$ and $\overline{\emptyset_{s2}}$. In the best case or fast timing conditions this time interval will be reduced to about 15 nS.

In the best case condition, ambient temperature is about 0.C and $V_{cc} = 5.5$ volts. The DRAM circuit may have to move the 800 pF. of capacitance associated with the bit lines from about 2.25 volts to about 5.5 volts in 15 nS. That requires 2600 picoCoulombs of charge to be supplied through the $V_{cc}$ pin. Even if it were possible to supply this amount of charge with a perfectly triangular current waveform (to minimize current surge), it would still require a current ramp rate of 45 mA. per nS. up to a maximum current peak of 350 mA. Both of these parameters are unacceptably high for the typical DRAM circuit and will tend to degrade the chip power supply. Also, peripheral circuits may fail after repeated such current surges.

Alternatively, if the DRAM is operating in its worst case condition the circuit will operate at its slowest speed. That is, when the ambient temperature is approximately 100°C and the power supply is approximately 4.5 volts, $t_0$ will be at its maximum value. Likewise, the $t_1$ MOS inverter delay period will be at its maximum inverter gates. The first sensing signal $\emptyset_{s1}$ will be initiated well into the chip active period, and the second sensing signal $\emptyset_{s2}$ will be generated after a relatively long delay at a time shortly before the chip active period terminates. Both of these sensing signals will be terminated at the end of the chip active period. Under these ambient conditions, the maximum current which may be generated is typically much less than would be generated under the best case conditions. Accordingly, the delay between the first and second sensing signals need not be as long to provide the desired current stabilization. However, because of the delays inherent in this approach, the access time for the DRAM becomes unacceptable.

Reference is also made to US-A-4421996 in which timing signals are produced using successive delays, i.e. each signal is dependent on the preceding signal.

Thus it can be seen that the known method for overcoming the inherent capacitance of the bit lines under certain operating conditions is incompatible with either the current limitations of the circuit or the fast access times required.

It is an object of the present invention to provide a method for allowing desirable access times with controlled current drawn through the DRAM circuitry over a wide range of operation conditions.

According to a first aspect of the invention there is provided a method of controlling sense and restore operations of a dynamic random access memory circuit having active and precharge periods, the method comprising:

initiating drive current to a sense amplifier in response to the initiation of the active period after a predetermined delay ($t_o$) to initiate the sense and restore operation;

subsequently generating a sensing signal ($\emptyset_{S2}$) and using the sensing signal to augment the drive current to the sense amplifier, characterised in that the sensing signal is initiated in response to an externally generated signal whereby generation of the sensing signal ($\emptyset_{S2}$) is independent of initiation of the drive current.

The invention generally provides a technique for controlling current spikes involved with the bit lines of a random access memory while permitting fast access times over an entire range of operating conditions such as ambient temperature and power supply variations. In a preferred embodiment the method comprises the steps of initiating a first sensing signal after a first delay period subsequent to the initiation of the active period. The first delay period varies with the temperature and power supply variations of the circuitry. The first sensing signal is used to turn on smaller devices in a sense amplifier so that current begins flowing. In this embodiment, the current will reach a peak and start to decay as the drain to source voltage decreases.

Subsequently, a second sensing signal is generated and used to turn on larger devices in the sense amplifier, so that further current is applied to overcome the bit line capacity in stages. However, unlike the prior art, where the generation of the second (or subsequent) sensing signals is dependent on the generation of a prior sensing signal, with the invention the second (or subsequent) sensing signal is not dependent. Furthermore, as the memory gets faster (as affected by operating conditions such as ambient temperature and VCC voltage level), the time interval between one sensing signal and a subsequent sensing signal will not decrease, but preferably will increase.

Preferably, the second sensing signal will be dependent on a relatively steady signal. Preferably, this will be the $\overline{RAS}$ signal which has a relatively stable low time. In a preferred embodiment, the generation of the second sensing signal will be dependent on a transition of $\overline{RAS}$. Preferably, the second (or ultimate) sensing signal will be generated to complete the sense and restore functions in response to $\overline{RAS}$ going high, which would normally denote the completion of the DRAM active period when the DRAM returns to the precharge stage. However, some of the $\overline{RAS}$ high time may be employed to complete the restore functions. This use of part of what would have been time dedicated to precharging the bit lines is feasible because where the precharge is to a level of $V_{cc}/2$, a fast precharge by shorting the bit lines together will still be possible in the remaining time. A method of the invention may further include the step of terminating the first and second sensing signals after a second delay period. The overall effect of the preferred method on cycle time is much less than merely extending the $\overline{RAS}$ low time. The result is an efficient sense and restore operation having inherently shorter cycle time then conventional circuitry, with proper access times over a wide range of conditions.

The method defined above may be used in a logic circuit including first logic means responsive to the initiation of the DRAM active period to generate a first or preliminary sensing signal after a first time delay determined by the time required to set up the bit lines for sensing. This first delay varies as a function of the circuit temperature and power supply variations. Second logic means then generates a second or final sensing signal in response illustratively to the completion of the DRAM active period at the initiation of the DRAM precharge period.

Apparatus according to the present invention may further include third logic means responsive to the completion of the DRAM active period to terminate the sensing signals after a second selectable, on-chip delay period.

In one embodiment of the invention there is provided means for compensating for ambient environment variations to control current surges in said circuit, said compensation means comprising:
control means responsive to the initiation of the active period to generate an enabling signal;
first generating means coupled to receive said enabling signal and responsive to the initiation of said active period to generate a first sensing signal after an ambient environment variable delay; and
second generating means coupled to receive said enabling signal in response to the termination of said active period to generate a second sensing signal.

An embodiment of the present invention will hereinafter be described, by way of example, with reference to the accompanying drawings, in which:-

Figure 1 shows a circuit diagram of a known dynamic RAM sense amplifier arranged to receive first and second paired sensing signals;

Figure 2 shows a diagram of known logic circuitry for generating first and second paired sensing signals $\emptyset_{s1}$ and $\emptyset_{s2}$;

Figure 3 shows schematically a circuit diagram of logic circuitry which may be used with the present invention to provide first and second paired sensing signals $\emptyset_{s1}$ and $\emptyset_{s2}$;

Figure 4 is a timing diagram illustrating the timing relationship of conventional first and second paired sensing signals; and

Figure 5 is a timing diagram illustrating the timing of various signals of an embodiment of the present invention.

As explained above, the traditional approach described with reference to Figures 1 and 2 does not properly accommodate time and temperature variations in the ambient conditions of DRAM circuitry. Because $t_0$ decreases during the "fast" operation of the DRAM in response to ideal conditions, $t_1$ will likewise decrease. Therefore, the first and second sensing signals will be closer together during a time when the current is more likely to surge to higher values which are unacceptable for the DRAM circuitry.

Figure 3 shows schematically logic circuitry of an embodiment of the invention for generating first and second paired sensing signals ($\emptyset_{s1}$, $\overline{\emptyset_{s1}}$ and $\emptyset_{s2}$, $\overline{\emptyset_{s2}}$) which can be used to drive a sense amplifier as illustrated in Figure 1.

In Figure 3, the row address strobe complement signal $\overline{RAS}$ is received on a line 60 and its complement $\emptyset_a$ is generated by way of an inverter on a line 62. These two signals $\overline{RAS}$ and $\emptyset_a$ are illustrated in Figure 5. In a manner similar to that of the conventional method, a first sensing signal $\emptyset_{s1}$ is generated at the output of a NOR gate 64 at a time $t_0$ after the initiation of the $\overline{RAS}$ signal ($\overline{RAS}$ drops low). Again, time $t_0$ represents the time required to set up the bit lines. This delay is affected by the temperature and power supply of the DRAM and is represented in Figure 3 by a delay block 66. First sensing signal $\emptyset_{s1}$ may be generated at the output of NOR gate 64 because both inputs to NOR gate 64 will be low at that time. A signal on a line 68, labelled $\emptyset$pre, will be low because the $\emptyset_a$ signal on the line 62 serves as one input to a NOR gate 70 and is high as long as $\overline{RAS}$ is low. This guarantees that the output of NOR gate 70 on line 68 will be low. Thus, the first sensing signal will lag behind the initiation of the chip active period by a time $t_0$ which represents the time required to set up the bit lines 10, 12, with $t_0$ being a variable dependent upon the temperature and power supply conditions of the dynamic RAM.

The generation of the second sensing signal

$\emptyset_{s2}$ allows the preferred embodiment to adequately compensate against current surges and to stabilize the overall current drawn by the dynamic RAM during its sense and restore function. Because the $\emptyset_a$ signal on line 62 also serves as an input to a NOR gate 72, the second sensing signal which is the output of a NOR gate 72 will not be generated until $\emptyset_a$ on line 62 falls to a low value. This can occur only when the $\overline{RAS}$ signal on line 60 goes high, indicating the termination of the active period and initiation of the chip precharge period. At that time, the second sensing signal can be generated at the output of the NOR gate 72. It should be noted that at this time the $\emptyset_{pre}$ signal on line 68 will remain low, because even though the $\emptyset_a$ signal on the line 62 input to the NOR gate 70 goes low, a $\emptyset_b$ signal on line 74, which is the other input to the NOR gate 70, remains high for a period $t_2$ following the initiation of the precharge period. In this manner, the second sensing signal is not generated by circuitry which receives the first sensing signal as an input. To this extent, the second sensing signal is generated independently of the time at which the first sensing signal is generated. Rather than following the first sensing signal by a time delay interposed by a predetermined number of inverters, the second sensing signal $\emptyset_{s2}$ will generally coincide with the initiation of the chip precharge period.

The generation of the second sensing signal independently of the first sensing signal enables adequate compensation for the temperature and power supply variations which may be found in the dynamic RAM operational environment to be made. Rather than the delay between the first and second sensing signals being determined by a time $t_1$ which varies with the temperature and power supply in the same way as $t_0$, that delay is now a function of the active period, and preferably is the total time that $\overline{RAS}$ is low minus $t_0$. Thus, when $t_0$ is at its smallest value (that is, the chip is operating in its fastest, best case mode), the delay between the first and second sensing signals will be at its longest. This is required because the conditions which cause the circuitry of the dynamic RAM to operate the fastest also provide the conditions most likely to produce an unacceptably high current surge through P channel transistor 28 if it is turned on too soon whilst the voltage differential is too great. Thus, in an embodiment of the invention, the P channel transistor 26 will typically be on for a longer period of time (and delivering charge) during those conditions in which unacceptably large current would be likely to surge through the large current transistor 28 if it were turned on quickly. By use of the invention, the maximum current drawn through the DRAM circuitry will not generally exceed that which is initially drawn through the P-channel transistor 26. Because the transistor 26 is a relatively small physical device, the current through it in most circumstances will be manageable.

When the DRAM (and its inverter circuits) are operating in the worst case mode (when it takes longer for the bit lines to be set up as measured by the time $t_0$, represented by block 66 in Figure 3), the time period separating the first and second sensing signals will be at its shortest. This is required because the conditions which create the slowness in setting up the bit lines are also the same conditions which are unlikely to generate excessive current at any time. Thus, the period between initiation of the first and second sensing signals may be shortened. Further, because the second sensing signal coincides with the initiation of the chip precharge period, the surge created by the $\overline{\text{RAS}}$ signal going high at this juncture assists in completing the sensing and restore operations.

As described above, the $\emptyset_b$ signal on the line 74 is the second input to the controlling NOR gate 70 in the circuit shown in Figure 3. This input is generated as a time delay of the $\emptyset_a$ signal present on the line 62. Accordingly, when $\emptyset_a$ on line 62 goes low, indicating the termination of the chip active period and the initiation of the chip precharge period, the signal on line 74 will correspondingly go low at a time $t_2$ later. When both the inputs to the NOR gate 70 are low, the $\emptyset_{pre}$ output of the NOR gate 70 on line 68 will go high which will disable the NOR gates 64 and 72 and terminate the first and second sensing signals. Accordingly, the duration of the second sensing signal may be determined by the time $t_2$ which is determined through a series of MOS inverters 76.

It will be appreciated that the second sensing signal endures for a period corresponding at least in part to the length of time necessary for the large current occasioned by the second sensing signal to accomplish the sense and restore functions. When the circuit is operating at a high temperature with a low power supply voltage, it is desirable for the second sensing signal to endure for a longer time to complete the sense and restore functions. In the described embodiment this will occur because the $t_2$ MOS delay is responsive to the same temperature and power supply variations that the $t_0$ delay responds to. This is in direct contrast to the conventional method in which the second sensing signal would endure for a shorter period of time when the circuit operates at its slowest.

The logic circuitry shown in Figure 3 is compatible with the sense amplifier shown in Figure 1. The first sensing signal at the output of the NOR gate 64 is supplied via the line 34 to the first N-channel transistor 30. The logical complement of the first sensing signal from the output of an inverter 78 is supplied by the line 38 to the first P-channel transistor 26. Likewise, the second sensing signal at the output of the NOR gate 72 is supplied via the line 36 to the second N-channel transistor 32, and the logical complement of the second sensing signal is supplied via the line 40 to the large current P-channel transistor 28. In the typical 256K dynamic RAM chip, there will be 1,024 sense amplifiers and pairs of bit lines. However, the logic circuitry of Figure 3 need be laid out on the chip architecture only once.

Figure 4 shows $\overline{\text{RAS}}$, the $\emptyset_{pre}$ signal, the first and second sensing signals $\emptyset_{s1}$ and $\emptyset_{s2}$ and the respective timing relationships of the signals in the conventional method for providing the sense and restore functions. It will be appreciated from a brief analysis of these waveforms that the sense and restore functions are always accomplished during the chip active period when the $\overline{\text{RAS}}$ signal is low.

Figure 5 shows a series of waveforms illustrating the relative timing between the $\overline{\text{RAS}}$ signal, the $\emptyset_{pre}$ signal, and the first and second sensing signals $\emptyset_{s1}$ and $\emptyset_{s2}$ and other signals generated in accordance with the invention. It will be appreciated from an analysis of these waveforms that the second sensing signal is initiated after the chip active period has terminated and the precharge period has begun. Further, the second sensing signal is generated independently of the first sensing signal and in fact will lag further behind the first sensing signal as the chip operates faster. This is a preferable method of completing the sense and restore functions with much less of an impact on the overall chip cycle time than would occur if the active period were extended to allow adequate completion of the sense and restore functions. This is especially true when midpoint sensing is utilized because the bit lines need only be shorted together to equilibrate them during the precharge period.

The present invention has been described above in terms of one embodiment, but changes and modifications may be made. For example, the invention is not limited to the provision only of two sensing signals, not to the application of signals to only two pairs of transistors. Other arrangements could be devised. There could be for instance, three or more pairs of transistors in the sense amplifier and a corresponding number of sensing signals. Some of the sensing signals may be functions of one another, while further sensing signals will be independent of other sensing signals. There could be plural transistor pairs in the sense amplifier with a lesser number of distinct sensing signals being distributed among them. Some of the sensing signals could be combined to form further sensing signals. Nor is the invention limited to generating the second or ultimate sensing signal in response to $\overline{\text{RAS}}$ going high. Other signals may be used or developed so that the interval between switching on transistors in the sense amplifier would not decrease, but preferably would increase, as the DRAM gets faster.

## Claims

1. A method of controlling sense and restore operations of a dynamic random access memory circuit having active and precharge periods, the method comprising:

   initiating drive current to a sense amplifier in response to the initiation of the active period after a predetermined delay ($t_o$) to initiate the sense and restore operation;

   subsequently generating a sensing signal ($\emptyset_{S2}$) and using the sensing signal to augment the drive current to the sense amplifier, characterised in that the sensing signal is initiated in response to an externally generated signal whereby generation of the sensing signal ($\emptyset_{S2}$) is independent of initiation of the drive current.

2. A method as claimed in claim 1, in which the sensing signal is terminated after a second time delay ($T_2$) from its initiation such that the sense and restore operation is completed during the precharge period.

3. A method as claimed in claim 1 or 2, wherein the sensing signal is generated in response to completion of the active period.

4. A method as claimed in claim 2 or 3, wherein said second time delay ($t_2$) is determinable by on-chip circuitry (76).

5. A method as claimed in any of claims 1 to 4, wherein said predetermined delay ($t_o$) comprises a time approximately equal to the time required to set up the bit lines on the chip.

6. A method as claimed in any of claims 1 to 5, wherein said predetermined delay varies with the ambient environment in said memory circuit.

7. A dynamic random access memory circuit having active and precharge periods and having means for stabilizing current surges, said stabilization means comprising:

   first logic means (64) responsive to the initiation of the active period to generate a first sensing signal ($\emptyset_{S1}$) after a first delay;

   second logic means (72) operable to generate a second sensing signal ($\emptyset_{S2}$);

   means for utilising successively the first and second sensing signals to initiate and augment drive current to a sense amplifier;

   characterised by third logic means (70) operable to initiate the second sensing signal in response to an externally generated signal whereby generation of the second sensing signal ($\emptyset_{S2}$) is independent of initiation of the first sensing signal.

8. A DRAM circuit as claimed in claim 7, wherein said first time delay is representative of the time required to set up the chip bit lines for sensing.

9. A DRAM circuit as claimed in claim 7 or 8, comprising means (66) for providing said first delay ($t_o$) as a function of the operating voltage and temperature of the circuit.

10. A DRAM circuit as claimed in claims 7, 8 or 9, in which the second logic means is operable to generate the second sensing signal in response to completion of the active period.

11. A DRAM circuit as claimed in claim 8 and 10 or claims 8, 9 and 10, wherein the active period is relatively constant whereby the time interval between generation of the first and second sensing signals increases as the bit line sensing set up time decreases and decreases and the bit line sensing set up time increases.

12. A DRAM circuit as claimed in any of claims 7 to 11, comprising means (76) for providing said second delay as a function of the operating voltage and temperature of the circuit.

13. A DRAM circuit as claimed in any of claims 7 to 12, wherein said third logic means is responsive to the initiation of the active period to enable said first and second logic means (64,72).

14. A DRAM circuit as claimed in any of claims 7 to 13, in which said second time delay ($t_2$) is determined by a series of MOS inverters (76).

15. A DRAM circuit as claimed in claims 10 and 13, comprising:

   control means responsive to the initiation of the active period to generate a control signal, the first logic means (66,64) being coupled to receive said control signal and responsive to the initiation of said active period to generate said first sensing signal ($\emptyset_{S1}$) after an ambient environment variable delay ($t_o$); and the second logic means (72) being coupled to receive said control signal and responsive to the termination of said active period to generate the second sensing signal ($\emptyset_{S2}$).

16. A DRAM circuit as claimed in claim 15, further comprising:

timing means (76) responsive to the termination of said active period and responsively coupled to said control means for causing said control means to cause said control signal to disable said first and second logic means at the preselected delay ($t_2$) after the active period termination, whereby the duration of said sensing signals ($\emptyset_{S1},\emptyset_{S2}$) is determined by said preselected delay.

17. A DRAM circuit as claimed in any of claims 7 to 16, including a sense amplifier (14,16,18,20) for sensing a voltage differential between the bit lines and having first and second current control inputs (30,32) coupled to receive respectively the first and second sensing signals.

18. A DRAM circuit as claimed in claim 17, wherein said current control inputs comprise the gates of respective first and second transistors, the first transistor being substantially smaller than the second transistor.

19. A DRAM circuit as claimed in claim 17 or 18, in which the sense amplifier has first and second paired inputs (34,36,38,40) to receive said first and second sensing signals ($\emptyset_{S1},\emptyset_{S2}$) and the logical complements ($\emptyset_{S1},\emptyset_{S2}$) of said sensing signals to drive said sense amplifier.

20. A DRAM circuit as claimed in claims 18 and 19, wherein said first paired inputs are coupled to the gates of a first pair of transistors (26,30) and said second paired inputs are coupled to the gates of a second pair of transistors (28,32) and wherein said second pair of transistors are substantially larger devices than said first pair of transistors.

21. A DRAM circuit as claimed in any of claims 7 to 20, wherein the third logic means is operable to initiate the second sensing signal in response to an externally generated signal whereby generation of the second sensing sig-

nal ($\emptyset_{S2}$) is independent of initiation of the first sensing signal.

## Revendications

1. Un procédé pour commander des opérations de lecture et de restauration d'un circuit de mémoire vive dynamique ayant des périodes actives et de précharge, ce procédé comprenant les opérations suivantes :

on commence à appliquer un courant d'attaque à un amplificateur de lecture sous l'effet du commencement de la période active, après un retard prédéterminé ($t_o$) pour déclencher l'opération de lecture et de restauration;

on génère ensuite un signal de lecture ($\emptyset_{S2}$) et on utilise le signal de lecture pour augmenter le courant d'attaque qui est appliqué à l'amplificateur de lecture, caractérisé en ce que le signal de lecture est déclenché sous l'effet d'un signal généré de façon externe, grâce à quoi la génération du signal de lecture ($\emptyset_{S2}$) est indépendante du commencement du courant d'attaque.

2. Un procédé selon la revendication 1, dans lequel on met fin au signal de lecture au bout d'une seconde durée de retard ($t_2$) à partir de son déclenchement, de façon que l'opération de lecture et de restauration soit entièrement accomplie pendant la période de précharge.

3. Un procédé selon la revendication 1 ou 2, dans lequel le signal de lecture est généré sous l'effet de l'achèvement de la période active.

4. Un procédé selon la revendication 2 ou 3, dans lequel la seconde durée de retard ($t_2$) peut être déterminée par un circuit incorporé sur la puce (76).

5. Un procédé selon l'une quelconque des revendications 1 à 4, dans lequel le retard prédéterminé ($t_o$) consiste en une durée approximativement égale à la durée nécessaire pour conditionner les lignes de bit sur la puce.

6. Un procédé selon l'une quelconque des revendications 1 à 5, dans lequel le retard prédéterminé varie avec l'environnement ambiant du circuit de mémoire.

7. Un circuit de mémoire vive dynamique ayant des périodes actives et de précharge et ayant des moyens de stabilisation visant à atténuer des pointes de courant, ces moyens de stabilisation comprenant :

des premiers moyens logiques (64) qui réagissent au début de la période active en générant un premier signal de lecture ($\emptyset_{S1}$) au bout d'un premier retard;

des seconds moyens logiques (72) conçus pour générer un second signal de lecture ($\emptyset_{S2}$);

des moyens destinés à utiliser successivement les premier et second signaux de lecture pour commencer à appliquer et pour augmenter un courant d'attaque dirigé vers un amplificateur de lecture;

caractérisé par des troisièmes moyens logiques (70) qui sont conçus de façon à déclencher le second signal de lecture sous l'effet d'un signal généré de façon externe, grâce à quoi la génération du second signal de lecture ($\emptyset_{S2}$) est indépendante du déclenchement du premier signal de lecture.

8. Un circuit de mémoire vive dynamique selon la revendication 7, dans lequel le premier retard est représentatif de la durée nécessaire pour conditionner les lignes de bit de la puce pour la lecture.

9. Un circuit de mémoire vive dynamique selon la revendication 7 ou 8, comprenant des moyens (66) qui sont destinés à produire le premier retard ($t_o$) en fonction de la tension d'alimentation et de la température du circuit.

10. Un circuit de mémoire vive dynamique selon les revendications 7, 8 ou 9, dans lequel les seconds moyens logiques sont conçus de façon à générer le second signal de lecture sous l'effet de l'achèvement de la période active.

11. Un circuit de mémoire vive dynamique selon les revendications 8 et 10 ou les revendications 8, 9 et 10, dans lequel la période active est relativement constante, grâce à quoi l'intervalle de temps entre la génération des premier et second signaux de détection augmente lorsque le temps de conditionnement des lignes de bit pour la lecture diminue, et cet intervalle de temps diminue lorsque le temps de conditionnement des lignes de bit pour la lecture augmente.

12. Un circuit de mémoire vive dynamique selon l'une quelconque des revendications 7 à 11, comprenant des moyens (76) destinés à produire le second retard en fonction de la tension d'alimentation et de la température du circuit.

13. Un circuit de mémoire vive dynamique selon l'une quelconque des revendications 7 à 12, dans lequel les troisièmes moyens logiques réagissent au commencement de la période active en validant les premiers et seconds moyens logiques (64, 72).

14. Un circuit de mémoire vive dynamique selon l'une quelconque des revendications 7 à 13, dans lequel le second retard ($t_2$) est déterminé par une série d'inverseurs MOS (76).

15. Un circuit de mémoire vive dynamique selon les revendications 10 et 13, comprenant :

des moyens de commande qui réagissent au commencement de la période active en générant un signal de commande, les premiers moyens logiques (66, 64) étant connectés de façon à recevoir ce signal de commande, et réagissant au commencement de la période active en générant le premier signal de lecture ($\emptyset_{S1}$) après un retard ($t_o$) qui varie en fonction de l'environnement ambiant; et les seconds moyens logiques (72) étant connectés de façon à recevoir le signal de commande et réagissant à la fin de la période active en générant le second signal de lecture ($\emptyset_{S2}$).

16. Un circuit de mémoire vive dynamique selon la revendication 15, comprenant en outre :

des moyens de temporisation (76) qui réagissent à la terminaison de la période active et qui sont connectés aux moyens de commande de façon à agir sur ces derniers, pour que les moyens de commande produisent le signal de commande de façon à invalider les premiers et seconds moyens logiques au bout du retard présélectionné ($t_2$) après la terminaison de la période active, grâce à quoi la durée des signaux de lecture ($\emptyset_{S1}$, $\emptyset_{S2}$) est déterminée par le retard présélectionné.

17. Un circuit de mémoire vive dynamique selon l'une quelconque des revendications 7 à 16, comprenant un amplificateur de lecture (14, 16, 18, 20) qui est destiné à détecter une différence de tension entre les lignes de bit, et qui comporte des première et seconde entrées de commande de courant (30, 32) qui sont connectées de façon à recevoir respectivement les premier et second signaux de lecture.

18. Un circuit de mémoire vive dynamique selon la revendication 17, dans lequel les entrées de commande de courant sont constituées par les grilles respectives d'un premier et d'un second transistors, le premier transistor étant notablement plus petit que le second transistor.

19. Un circuit de mémoire vive dynamique selon la revendication 17 ou 18, dans lequel l'amplificateur de lecture comporte des premières et secondes entrées associées par paires (34, 36, 38, 40), pour recevoir les premier et second signaux de lecture ($\emptyset_{S1}$, $\emptyset_{S2}$), et les compléments logiques ($\overline{\emptyset_{S1}}$, $\overline{\emptyset_{S2}}$) des signaux de lecture, pour attaquer l'amplificateur de lecture.

20. Un circuit de mémoire vive dynamique selon les revendications 18 et 19, dans lequel les premières entrées associées par paire sont connectées aux grilles d'une première paire de transistors (26, 30), et les secondes entrées associées par paire sont connectées aux grilles d'une seconde paire de transistors (28, 32), et dans lequel les transistors de la seconde paire de transistors sont notablement plus grands que ceux de la première paire de transistors.

21. Un circuit de mémoire vive dynamique selon l'une quelconque des revendications 7 à 20, dans lequel les troisièmes moyens logiques peuvent fonctionner de façon à déclencher le second signal de lecture sous l'effet d'un signal généré de manière externe, grâce à quoi la génération du second signal de lecture ($\emptyset_{S2}$) est indépendante du déclenchement du premier signal de lecture.

**Patentansprüche**

1. Verfahren zum Steuern der Anfrage- und Auffrischoperationen eines dynamischen Schreib-Lese-Speichers mit Aktivierungs- und Vorladungsperioden, das folgende Verfahrensschritte umfaßt:

   Initiieren eines Treiberstroms an einem Abfrageverstärker, abhängig von der Initiierung der Aktivierungsperiode nach einer vorbestimmten Verzögerungszeit ($t_0$), um die Abfrage- und Auffrischoperationen einzuleiten;

   nachfolgendes Erzeugen eines Abfragesignals ($\emptyset_{S2}$) und Verwenden des Abfragesignals, um den Treiberstrom an dem Abfrageverstärker zu vergrößern,

   dadurch gekennzeichnet,
   daß das Abfragesignal abhängig von einem extern erzeugten Signal initiiert wird, wodurch das Abfragesignal ($\emptyset_{S2}$) unabhängig von der Initiierung des Treiberstroms erzeugt wird.

2. Verfahren nach Anspruch 1, dadurch gekennzeichnet, daß das Abfragesignal nach einer zweiten Verzögerungszeit ($t_2$) ab seiner Initiierung beendet wird, damit die Abfrage- und Auffrischoperation während der Vorladungsperiode abgeschlossen wird.

3. Verfahren nach Anspruch 1 oder 2, dadurch gekennzeichnet, daß das Abfragesignal abhängig von dem Abschluß der Aktivierungsperiode erzeugt wird.

4. Verfahren nach Anspruch 2 oder 3, dadurch gekennzeichnet, daß die zweite Verzögerungszeit ($t_2$) durch einen Chip-Schaltkreis (76) bestimmt wird.

5. Verfahren nach einem der Ansprüche 1 bis 4, dadurch gekennzeichnet, daß die vorbestimmte Verzögerungszeit ($t_0$) eine Zeitdauer aufweist, die annähernd gleich der Zeitdauer ist, um die Bit-Leitungen auf dem Chip aufzubauen.

6. Verfahren nach einem der Ansprüche 1 bis 5, dadurch gekennzeichnet, daß die vorbestimmte Verzögerungszeit mit der Umgebungsbedingung in der Speicherschaltung variiert.

7. Dynamische Schreib-Lese-Speicherschaltung, die Aktivierungs- und Vorladungsperioden sowie eine Einrichtung zum Stabilisieren von Stromstößen aufweist, die umfaßt:

   Eine erste Logikeinrichtung (64), die auf die Initiierung der Aktivierungsperiode anspricht, um ein erstes Abfragesignal ($\emptyset_{S1}$) nach der ersten Verzögerungszeit zu erzeugen;

   eine zweite Logikeinrichtung (72), die betriebsfähig ist, um ein zweites Abfragesignal ($\emptyset_{S2}$) zu erzeugen;

   Einrichtungen zum aufeinanderfolgenden Benutzen der ersten und zweiten Abfragesignale, um Treiberstrom an einem Abfrageverstärker zu initiieren und zu vergrößern;

   gekennzeichnet durch eine dritte Logikschaltung (70), die betriebsfähig ist, um das zweite Abfragesignal abhängig von einem extern erzeugten Signal zu initiieren, wodurch das zweite Abfragesignal ($\emptyset_{S2}$) unabhängig von der Initiierung des ersten Abfragesignals erzeugt wird.

8. DRAM-Schaltung nach Anspruch 7, dadurch gekennzeichnet, daß die erste Verzögerungszeit der Zeitdauer entspricht, die erforderlich ist, um die Chip-Bit-Leitungen zum Abfragen aufzubauen.

9. DRAM-Schaltung nach Anspruch 7 oder 8, dadurch gekennzeichnet, daß Einrichtungen(66)- zum Ausbilden der ersten Verzögerungszeit ($t_0$) entsprechend einer Funktion der Betriebsspannung und der Temperatur der Schaltung vorgesehen sind.

10. DRAM-Schaltung nach den Ansprüchen 7, 8 oder 9, dadurch gekennzeichnet, daß die zweite Logikeinrichtung betriebsfähig ist, um das zweite Abfragesignal abhängend von dem Abschluß der Aktivierungsperiode zu erzeugen.

11. DRAM-Schaltung nach Anspruch 8 und 10 oder Anspruch 8, 9 und 10, dadurch gekennzeichnet, daß die Aktivierungsperiode relativ konstant ist, wodurch das Zeitintervall zwischen dem Erzeugen der ersten und zweiten Abfragesignale zunimmt wie die Bit-Leitungs-Abfrageaufbauzeit abnimmt und abnimmt wie die Bit-Leitungs-Abfrageaufbauzeit zunimmt.

12. DRAM-Schaltung nach einem der Ansprüche 7 bis 11, dadurch gekennzeichnet, daß Einrichtungen 76 zum Ausbilden der zweiten Verzögerungszeit entsprechend einer Funktion der Betriebsspannung und der Temperatur der Schaltung vorgesehen sind.

13. DRAM-Schaltung nach einem der Ansprüche 7 bis 12, dadurch gekennzeichnet, daß die dritte Logikeinrichtung auf die Initiierung der Aktivierungsperiode anspricht, um die erste und zweite Logikeinrichtung (64, 72) freizugeben.

14. DRAM-Schaltung nach einem der Ansprüche 7 bis 13, dadurch gekennzeichnet, daß die zweite Verzögerungszeit ($t_2$) durch eine Serie von MOS-Invertern (76) vorbestimmt wird.

15. DRAM-Schaltung nach den Ansprüchen 10 und 13, dadurch gekennzeichnet, daß vorgesehen sind:

Kontrolleinrichtungen, die auf die Initiierung der Aktivierungsperiode ansprechen, um ein Steuersignal zu erzeugen, und an die die erste Logikeinrichtung (66, 64) angeschlossen ist, um das Steuersignal zu empfangen und abhängend von der Initiierung der Aktivierungsperiode das erste Abfragesignal ($\emptyset_{S1}$) nach einer variablen Umgebungsbedingung-Verzögerungszeit (t) zu erzeugen; und an die die zweite Logikeinrichtung (72) angeschlossen ist, um das Steuersignal zu Empfangen und abhängend vom Beenden der Aktivierungsperiode das zweite Abfragesignal ($\emptyset_{S2}$) zu erzeugen.

16. DRAM-Schaltung nach Anspruch 15, dadurch gekennzeichnet, daß weiter vorgesehen sind: Zeitgebereinrichtungen 76, die auf das Ende der Aktivierungsperiode ansprechen und ansprechbar an die Steuereinrichtungen gekoppelt sind, damit die Steuereinrichtung das Steuersignal veranlaßt, die erste und zweite Logikeinrichtung zu der vorausgewählten Verzögerungszeit ($t_2$) nach dem Aktivierungsperiodenabschluß außer Betrieb zu setzen, wodurch die Dauer der Abragesignale ($\emptyset_{S1}$, $\emptyset_{S2}$) durch die vorausgewählte Verzögerungszeit bestimmt wird.

17. DRAM-Schaltung nach einem der Ansprüche 7 bis 16, dadurch gekennzeichnet, daß ein Abfrageverstärker (14, 16, 18, 20) zum Abfragen einer Spannungsdifferenz zwischen den Bit-Leitungen vorhanden ist, der erste und zweite Stromsteuereingänge (30, 32) aufweist, die angeschlossen sind, um das erste bzw. zweite Abfragesignal zu empfangen.

18. DRAM-Schaltung nach Anspruch 17, dadurch gekennzeichnet, daß die Stromsteuereingänge Gatter von erstem bzw. zweitem Transistoren enthalten, wobei der erste Transistor im wesentlichen kleiner als der zweite Transistor ist.

19. DRAM-Schaltung nach Anspruch 17 oder 18, dadurch gekennzeichnet, daß der Abfrageverstärker erste und zweite gepaarte Eingänge (34, 36, 38, 40) aufweist, um die ersten und zweiten Abfragesignale ($\emptyset_{S1}$, $\emptyset_{S2}$) und die logischen Komplementäre ($\emptyset_{S1}$, $\emptyset_{S2}$) der Abfragesignale zu empfangen, damit der Abfrageverstärker angesteuert wird.

20. DRAM-Schaltung nach den Ansprüchen 18 und 19, dadurch gekennzeichnet, daß die ersten gepaarten Eingänge an die Gatter eines ersten Paares von Transistoren (26, 30) und daß die zweiten gepaarten Eingänge an die Gatter eines zweiten Paares von Transistoren (28, 32) angeschlossen sind, wobei das zweite Paar von Transistoren im wesentlichen größere Einrichtunge sind, als das erste Paar von Transistoren.

21. DRAM-Schaltung nach einem der Ansprüche 7 bis 20, dadurch gekennzeichnet, daß die dritte Logikeinrichtung betriebsfähig ist, um das zweite Abfragesignal abhängig von einem extern erzeugten Signal zu initiieren, wodurch die Erzeugung des zweiten Abfragesignals ($\emptyset_{S2}$) unabhängig von der Initiierung des ersten Abfragesignals ist.

FIG. 1

FIG. 2

FIG. 3

## FIG. 4

$\overline{RAS}$

$\phi_{PRE}$

$\leftarrow t_o \rightarrow$

$\phi_{SI}$

$\overline{\phi_{SI}}$

$\rightarrow | t_1 | \leftarrow$

$\phi_{S2}$

$\overline{\phi_{S2}}$

## FIG. 5

$\overline{RAS}$

$\phi_a$

$\phi_b$ — $| t_2 |$

$\phi_{PRE}$

$\leftarrow t_o \rightarrow$

$\phi_{SI}$

LEADING EDGE — $| t_2 |$

$\phi_{S2}$

$\overline{\phi_{S2}}$

$\overline{\phi_{SI}}$

13